# FASCICULE DE BREVET EUROPEEN

(11) **EP 0 729 584 B1**
(45) Date de publication et mention de la délivrance du brevet: **02.07.1997**
(21) Numéro de dépôt: 95902154.4
(22) Date de dépôt: 18.11.1994
(51) Int. Cl.: G01R 31/02

(54) **DISPOSITIF DE TESTS ELECTRIQUES D'UN ELEMENT DE LIAISON ELECTRIQUE**
VORRICHTUNG ZUM ELEKTRISCHEN PRÜFEN EINES ELEMENTS EINER ELEKTRICHEN VERBINDUNG
DEVICE FOR ELECTRICALLY TESTING AN ELECTRICAL CONNECTION MEMBER

(30) Priorité: 18.11.1993 FR 9313775
(43) Date de publication de la demande: 04.09.1996
(73) Titulaire: AXON'CABLE S.A., 51210 Montmirail (FR)
(72) Inventeur: ROUCHAUD, Gilles, F-51210 Montmirail (FR)
(74) Mandataire: Dronne, Guy
(86) Numéro de dépôt international: FR9401349
(87) Numéro de publication internationale: WO9514237

(56) Documents cités:
- EP-A- 0 103 971
- FR-A- 2 603 112

## Description

La présente invention a pour objet un dispositif de tests électriques d'un élément de liaison électrique constitué par une ligne principale et n lignes de dérivations raccordées à la ligne principale par des coupleurs.

De façon plus précise, l'invention concerne un dispositif qui permet d'appliquer des tests électriques pour déterminer et vérifier les propriétés de transmission électrique entre différents composants électriques qui sont raccordés sur une ligne principale par des lignes dérivées raccordées à la ligne principale par des coupleurs. On rencontre un certain nombre d'implantations électriques dans lesquelles on trouve différents composants électriques ou électroniques constitués notamment par des capteurs ou des actuateurs qui échangent entre eux des informations par l'intermédiaire d'une ligne principale unique, ce type de liaison étant le plus souvent appelé BUS ou harnais/BUS. Cette disposition se trouve notamment dans les circuits électriques implantés, par exemple dans les fusées spatiales pour relier entre eux différents capteurs ou différents actuateurs de la fusée. Compte tenu du coût d'une telle fusée et de son lancement, il est évidemment déterminant que les éléments de liaison électrique entre ces différents composants puissent être entièrement testés avant leur mise en place dans la fusée ou dans une installation similaire afin d'éviter des risques de panne ou de mauvais fonctionnement.

Dans le cas particulier des installations spatiales, ce type d'interconnexion dit harnais/bus doit satisfaire à la norme MIL-STD-1553B. Cependant, pour d'autres types d'installation, il est nécessaire de vérifier que les interconnexions satisfont à des normes de même type.

D'une manière générale, les différents systèmes d'interconnexion doivent être testés dans différentes configurations, c'est-à-dire lorsque successivement chacun des composants reliés par les lignes de dérivation se comporte en émetteur, lorsqu'il se comporte en récepteur, lorsqu'on lui applique une charge d'entrée qui simule une carte c'est-à-dire un circuit électronique et éventuellement lorsque l'un des récepteurs ou émetteurs qui sera appelé ultérieurement abonné est en court-circuit ou en circuit ouvert afin de simuler une avarie sur l'ensemble de l'installation en vue de tester son comportement dans une telle configuration.

On comprend aisément que, lorsque le harnais/bus sert à interconnecter un nombre important de composants, par exemple une dizaine, le nombre de configurations différentes à tester pour s'assurer que chaque liaison dérivée est convenablement couplée à la ligne principale est extrêmement élevé.

Avec les moyens utilisés actuellement qui sont des moyens essentiellement manuels et non automatiques, le temps qui serait requis pour tester effectivement chacune des configurations devient prohibitif. En conséquence, seul un nombre limité de configurations critiques est effectivement testé. On comprend que, si une telle procédure de tests permet statistiquement de détecter les pannes ou avaries les plus fréquentes, elles ne permettent pas de s'assurer que l'installation d'interconnexions fonctionnera effectivement dans toutes ses configurations possibles.

Comme on l'a déjà indiqué brièvement, lorsque ce système d'interconnexions et la qualité de son fonctionnement sont des points critiques pour le fonctionnement d'une fusée ou d'un matériel similaire dont le coût est très élevé, il est intéressant de s'assurer de façon aussi complète que possible du bon fonctionnement des liaisons électriques avant de réaliser le montage de celle-ci sur la fusée.

Pour remédier aux inconvénients des techniques de l'art antérieur, l'invention a pour objet un dispositif de tests électriques d'une liaison électrique du type harnais/bus qui permet automatiquement et de préférence à l'aide de moyens informatiques de contrôler et de tester l'ensemble des configurations que peuvent présenter les différents composants qui sont reliés par l'élément de liaison électrique en simulant leurs différentes situations ou éventuellement leurs avaries.

Pour atteindre ce but, le dispositif de tests électriques d'un élément de liaison électrique constitué par une ligne principale et n lignes de dérivations raccordées à la ligne principale par des coupleurs se caractérise en ce qu'il comprend :
m circuits d'état de ligne de dérivation, m ≥ n, chaque circuit d'état comprenant une entrée connectée à une ligne de dérivation, des moyens commutateurs pour relier ladite entrée à une parmi deux paires de sorties ou à au moins un composant interne audit circuit et des moyens de commande pour commander lesdits moyens commutateurs ;
un générateur de signaux électriques commandable ;
un premier ensemble de commutation comprenant une entrée reliée audit générateur de signaux, m paires de contacts, chaque paire de contacts étant reliée électriquement à la première paire de sorties d'un desdits circuits d'état de ligne de dérivation, et des moyens de commande pour relier sélectivement ladite entrée à une desdites paires de contacts dudit premier ensemble de commutation ;
un dispositif de mesure de signaux électriques ;
un deuxième ensemble de commutation comprenant une sortie reliée audit dispositif de mesure, m paires de bornes d'entrée de connexion, chaque paire de bornes d'entrée étant reliée électriquement à la deuxième paire de sortie d'un des circuits d'état de ligne de dérivation, et des moyens de commande pour relier sélectivement ladite sortie à une desdites paires de bornes d'entrée de connexion dudit deuxième ensemble de commutation ; et
un ensemble de commande pour commander lesdits moyens de commande des circuits d'état de ligne de dérivation et desdits premier et deuxième ensembles de commutation et pour commander l'élaboration d'un signal électrique par ledit générateur de signaux en fonction d'un programme de tests dudit élément de liaison électrique.

On comprend que, selon l'invention, la réalisation de la simulation des divers états de tests des composants interconnectés par le harnais/bus se fait grâce à deux étages de commutation. D'une part, le premier étage où chaque ligne de dérivation est connectée à un circuit dit d'état de ligne de dérivation ultérieurement appelé carte "abonné", permet de simuler que le composant fictivement connecté à cette dérivation se comporte comme un émetteur ou un récepteur ou qu'il n'est ni l'un ni l'autre ou encore qu' il présente un défaut tel qu'un court-circuit ou un circuit ouvert.

Le deuxième étage est constitué par les deux ensembles de commutation qui permettent de relier sélectivement chaque carte "abonné" soit au générateur de signaux électriques par le premier ensemble de commutation, soit au dispositif de mesure de signaux électriques par le deuxième ensemble de commutation, ces deux liaisons pouvant bien sûr être réalisées simultanément.

En commandant les "positions" des ensembles de commutation et les connexions réalisées par les cartes "abonné", on peut successivement faire prendre à chacun des composants reliés par l'ensemble de liaisons électriques les différents états qui doivent être pris en compte dans le test.

Selon un mode préféré de mise en oeuvre, chaque ensemble de commutation comprend :
deux lignes formant ladite entrée du premier ensemble de commutation et de ladite sortie du deuxième ensemble de commutation;
p lignes de commutateur, 2P ≥ m, la ligne i comportant 2ⁱ commutateurs, chaque commutateur comprenant une borne d'entrée, une première et une deuxième bornes de sortie et des moyens de liaison électrique commandables pour relier sélectivement ladite borne d'entrée à ladite première borne ou à ladite deuxième borne de sortie, chacune desdites première ou deuxième bornes de sortie des commutateurs de la ligne i étant reliée électriquement à la borne d'entrée d'un commutateur de la ligne i+1, les deux bornes externes étant reliées respectivement aux bornes d'entrée des deux commutateurs de la première ligne ; et
des moyens de commande pour commander simultanément les moyens de liaison électrique commandables de la totalité des commutateurs d'une même ligne de telle manière que pour tous les commutateurs d'une même ligne la borne d'entrée soit reliée à la première borne de sortie ou soit reliée à la deuxième borne de sortie selon les états binaires de commande ;
chacune des 2P premières bornes de sortie et chacune des 2P deuxièmes bornes de sortie étant reliée à l'une des bornes d'entrée ou de sortie de connexion et les premières et deuxièmes bornes de sortie des commutateurs de la i^{ième} ligne étant reliées aux bornes d'entrée des commutateurs de la (i+1)^{ième} ligne de telle manière que, pour chaque combinaison des états binaires de commande des moyens de commande des lignes de commutateurs, les deux bornes externes dudit ensemble de commutation puissent être reliées à une quelconque unique paire de bornes d'entrée ou de sortie de connexion.

On comprend que l'ensemble de commutation est constitué par une structure arborescente binaire d'ensembles de commutateurs disposés selon des lignes. L'état des commutateurs d'une même ligne est commandé simultanément et l'état de commande de chaque ligne de commutateur permet de relier électriquement les bornes externes de l'ensemble de commutation à une unique paire de bornes de sortie ou d'entrée de connexion, ces paires de bornes étant elles-mêmes reliées aux circuits d'état de ligne de dérivation, c'est-à-dire aux cartes "abonné". Cette disposition arborescente permet de simplifier la commande de l'ensemble de commutation tout en permettant de relier de façon unique les bornes externes d'entrée ou de sortie aux bornes de connexion de sortie ou d'entrée elles-mêmes reliées aux cartes "abonné". Cette disposition permet aussi de raccourcir la longueur de ligne.

D'autres caractéristiques et avantages de la présente invention apparaîtront mieux à la lecture de la description qui suit d'un mode préféré de réalisation de l'invention donné à titre d'exemple non limitatif. La description se réfère aux figures annexées sur lesquelles :
- la figure 1 est un schéma bloc de l'ensemble du dispositif de tests électriques ;
- la figure 2 est un schéma illustrant l'ensemble de commutation en émission et une carte "abonné" ; et
- la figure 3 est une vue semblable à celle de la figure 2 mais montrant l'ensemble de commutation en réception.

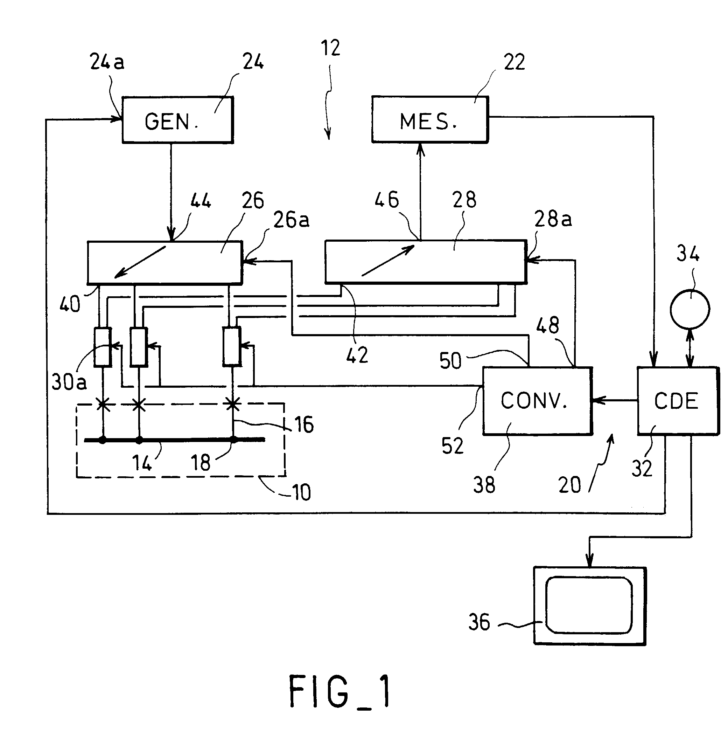

En se référant tout d'abord à la figure 1, on va décrire l'ensemble du dispositif de test électrique.

Sur la figure 1, on a représenté le bus 10 à tester qui est connecté au dispositif de test 12. Le bus 10 est constitué par une ligne principale 14 sur laquelle sont connectées n lignes dérivées 16. Chaque ligne dérivée 16 est raccordée à la ligne principale 14 par un coupleur électrique 18.

Le dispositif de test électrique se compose essentiellement d'un ensemble de commande 20 permettant d'appliquer et de commander la batterie de tests à faire subir au bus 10, un appareil de mesure électrique 22 tel qu'un oscilloscope ou un enregistreur, un générateur de signaux électriques 24 commandable, un premier et un deuxième commutateur électrique, respectivement référencés 26 et 28, et m circuits d'état de lignes dérivées portant la référence générique 30 qui seront ultérieurement appelés par simplification cartes "abonné".

L'ensemble de commande 20 est essentiellement constitué par une machine informatique 32 associée à une mémoire de programme 34 qui permet de commander le déroulement des différentes configurations de tests à appliquer au bus 10. Le dispositif informatique 32 est de préférence associé à des moyens d'affichage et d'impression de résultats 36. Le dispositif de commande informatique 32 est également couplé à un convertisseur 38 qui permet de convertir les instructions émises par le dispositif informatique 32 en des signaux de commande exécutables permettant de contrôler l'état des différents composants du dispositif de tests 12. Le dispositif de commande informatique 32 est également relié à l'entrée de commande 24a du générateur de signaux électriques 24 afin de définir la forme du signal électrique qui sera appliqué pour la phase de tests considérée.

Plus précisément, comme le montre la figure 1, chaque ligne dérivée 16 du bus 10 est raccordée à l'entrée et/ou à la sortie d'une carte "abonné" 30. Chaque carte "abonné" 30 est raccordée à une sortie 40 du premier commutateur 26 et à une entrée 42 du deuxième commutateur 28. Le commutateur 26 a son entrée 44 qui est raccordée à la sortie du générateur de signaux électriques 24 alors que la sortie 46 du deuxième commutateur 28 est raccordée à l'entrée du dispositif de mesure électrique 22. Le convertisseur 38 présente une première sortie 48 qui est raccordée à l'entrée de commande 28a du commutateur 28 et une deuxième sortie de commande 50 qui est raccordée à l'entrée de commande 26a du premier commutateur 26.

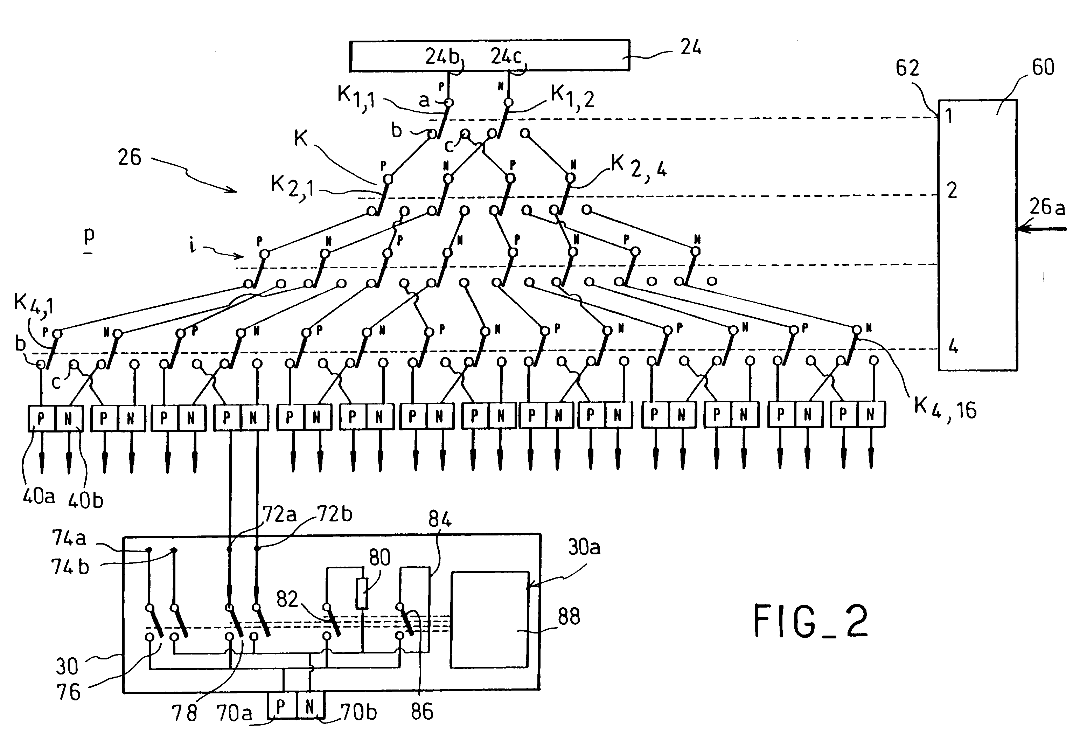

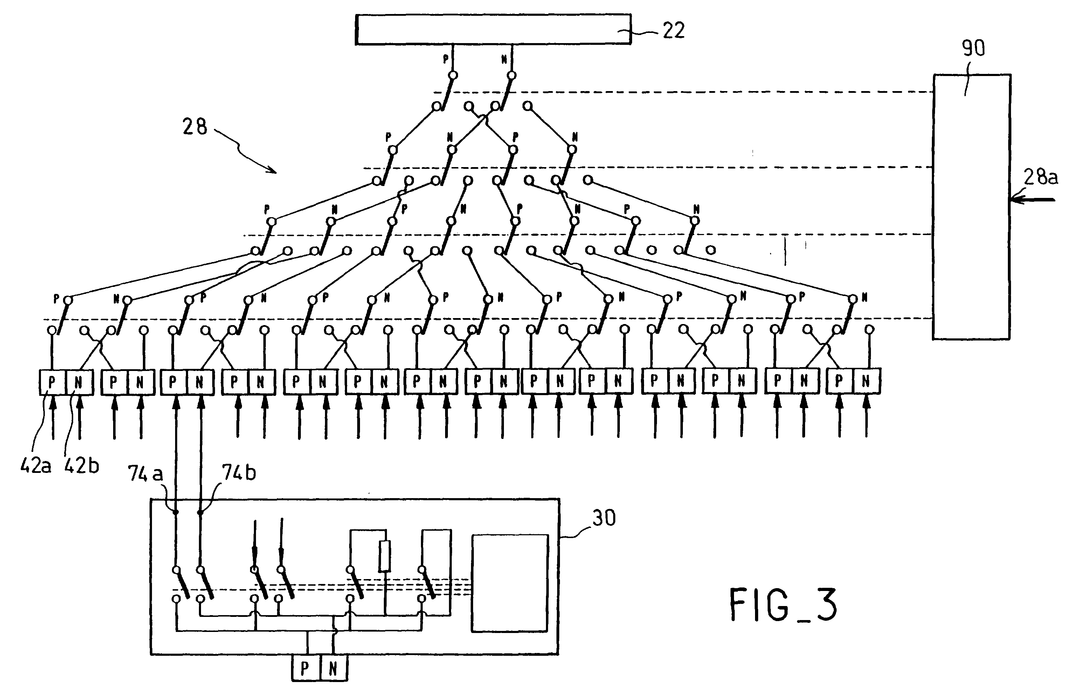

Comme on l'expliquera ultérieurement plus en détails en liaison avec les figures 2 et 3, le commutateur 26 permet de relier son entrée 44 à une des sorties 40 de ce commutateur et donc à une des m cartes "abonné" 30. De la même manière, le commutateur 28 permet de relier une de ses entrées 42, c'est-à-dire une des cartes "abonné" 30 à sa sortie 46, c'est-à-dire à l'appareil de mesure 22. Le dispositif de conversion 38 comporte une troisième sortie de commande 52 qui est reliée à l'entrée de commande 30a de chacune des cartes "abonné" 30. Le convertisseur par sa sortie 52 peut appliquer à chaque carte "abonné" un signal de commande qui permet, comme on l'expliquera plus en détails ultérieurement, de définir l'état de chacune des lignes dérivées 16 lors d'une phase de tests. Selon le signal de commande appliqué sur les entrées 30a des cartes "abonné" 30. Celle-ci peut relier la ligne dérivée qui lui est associée au générateur de signaux électriques 24 ou bien à l'appareil de mesure 22 ou à aucun de ces deux dispositifs. Dans ce dernier cas, le signal de commande peut mettre la carte "abonné" dans un état correspondant à un court-circuit de la ligne de dérivation 16 correspondante ou représenter la charge normale de fonctionnement appliquée à celle-ci.

On va maintenant décrire le principe de fonctionnement du dispositif de tests électriques 12. Pour chaque étape d'une série de tests, une ligne dérivée est émettrice, une ligne dérivée est réceptrice et les autres lignes dérivées sont soit en court-circuit pour simuler une panne, soit en circuit ouvert, soit affectées de leur charge normale. La mise en oeuvre de l'étape de tests consiste donc à définir par le programme 34 le numéro de la ligne dérivée 16 émettrice, le numéro de la ligne dérivée 16 réceptrice et l'état de chacune des autres lignes dérivées. Il faut également définir l'information donnant les caractéristiques du signal qui devra être émis par la ligne dérivée émettrice et éventuellement la nature des mesures à effectuer.

Ces différentes informations sont transmises au convertisseur 38 qui va commander d'une part les différentes cartes "abonné" 30 en fonction de l'état de la ligne dérivée qui leur est associé. Plus précisément, une des cartes "abonné" sera commandée pour relier la ligne dérivée au générateur 24 de signaux électriques et une autre carte pour relier la carte "abonné" à l'appareil de mesure 22. Les autres cartes "abonné" sont commandées pour prendre un des autres états possibles. Simultanément le convertisseur 38 commande les commutateurs 26 et 28 de telle manière que la carte "abonné" émettrice soit effectivement reliée au générateur 24 et que la carte "abonné" réceptrice soit effectivement reliée à l'appareil de mesure 22. En outre, le générateur de signaux électriques 24 est commandé pour appliquer la forme de signal électrique souhaité pour le test. Lorsque ces différentes connexions ont été réalisées, l'appareil de mesure 22 élabore les mesures de caractéristiques électriques prévues dans le test, ces mesures étant transmises au dispositif informatique 32 qui permet leur traitement et éventuellement leur affichage sur le dispositif d'affichage 36 ou sur un support papier ou encore leur mémorisation sur un support informatique.

On comprend que, grâce à l'organisation générale du dispositif de tests, il est possible effectivement dans un laps de temps relativement limité de faire jouer à chacune des lignes dérivées le rôle d'un émetteur en la combinant successivement à chacune des autres lignes dérivées jouant le rôle de récepteur et en combinant ces différents états aux différentes configurations possibles pour les autres lignes dérivées ne jouant ni le rôle d'émetteur, ni le rôle de récepteur. En effet, le passage d'une configuration à une autre est automatiquement commandé par le programme informatique mis en oeuvre par le dispositif informatique 32 dont les instructions sont converties en signaux électriques de commande par le convertisseur 38.

En se référant maintenant à la figure 2, on va décrire un mode préféré de réalisation du premier commutateur 26 permettant de relier les cartes "abonné" aux générateurs de signaux électriques 24 ainsi qu'un mode préféré de réalisation d'une carte "abonné" 30.

Le commutateur 26 est essentiellement constitué par p lignes de commutateurs élémentaires portant la référence générique K. La première ligne de commutateurs est constituée par deux commutateurs élémentaires K_{1,1} et K_{1,2} dont les entrées portant la référence générique a sont respectivement raccordées aux bornes de sortie 24b et 24c du générateur 24. De façon générique, chaque commutateur K_{i,j} comporte deux bornes de sortie respectivement référencées b et c. La deuxième ligne de commutateur comprend quatre commutateurs élémentaires portant donc les références K_{2,1} à K_{2,4}. Chaque première borne de sortie b d'un commutateur de la ligne i est reliée à la borne d'entrée a d'un commutateur de la ligne i+1 et chaque borne de sortie c d'un commutateur de la ligne i est raccordée à l'entrée a d'un autre commutateur de la ligne i+1. On obtient ainsi une structure arborescente de commutateurs, une ligne i comportant deux fois plus de commutateur que la ligne i-1. Plus généralement, la ligne i de commutateurs élémentaires K_{i,j} comporte 2ⁱ commutateurs. Dans l'exemple considéré, l'ensemble de commutation comporte quatre lignes de commutateurs élémentaires, ce qui signifie que la quatrième ligne comporte 2⁴ commutateurs élémentaires référencés K_{4,1} à K_{4,16}. Les sorties b et c des commutateurs élémentaires K de la dernière ligne sont reliées respectivement aux bornes externes de sortie positives 40a de l'ensemble de commutation et aux bornes 40b négatives de l'ensemble de commutation.

Comme le montre également la figure 2, le commutateur comporte un ensemble de commande 60 comportant autant de sorties de commande 62 qu'il y a de lignes de commutateurs élémentaires, c'est-à-dire quatre dans l'exemple considéré. Chaque sortie 62 du dispositif de commande 60 permet de relier simultanément les entrées a des commutateurs élémentaires d'une même ligne aux bornes b de sortie ou simultanément aux bornes c de sortie. Une instruction complète de commande du commutateur 26 consiste donc dans quatre informations binaires indiquant si les commutateurs d'une ligne i doivent être dans une position qui relie son entrée a à la borne c ou dans une position qui relie son entrée a à la borne b.

Les liaisons électriques entre les bornes de sortie b, c des commutateurs élémentaires Kᵢ de la ligne i et les bornes a des commutateurs Kᵢ₊₁ de la ligne i+1 sont telles que les sorties 24b et 24c du générateur électrique 24 puissent être reliées à n'importe laquelle des paires de bornes de sortie externe du commutateur 20, 40a et 40b et à une seule paire. La figure 2 montre une configuration possible de ces connexions électriques.

En d'autres termes, lorsqu'un signal de commande est appliqué à l'entrée 26a du dispositif de commande 60 du commutateur 26, les commutateurs des différentes lignes prennent un état qui permet de relier le générateur 24 à la paire de bornes externes de sortie 40a, 40b choisies, c'est-à-dire qui permettent de relier le générateur 24 à une carte "abonné" 30 déterminée.

En se référant toujours à la figure 2, on va décrire un mode préféré de réalisation d'une carte "abonné" 30. Celle-ci comporte une première paire d'entrée/sortie constituée par la borne positive 70a et la borne négative 70b. Les bornes 70a et 70b, comme on l'a déjà expliqué, sont connectées à une ligne dérivée 16 du bus 10 à tester. La carte "abonné" comporte une deuxième paire de bornes de connexion externe 72a, 72b qui est destinée à être reliée à une paire de bornes externes de sortie 40a, 40b du commutateur 26. La carte 30 comporte également une troisième paire de bornes externes 74a, 74b destinées à être connectées aux bornes externes d'entrée du commutateur 28, comme on l'expliquera ultérieurement. Des commutateurs bi-polaires 76 et 78 permettent d'assurer la liaison entre les bornes 70a, 70b et respectivement les bornes 72a, 72b et 74a, 74b ou au contraire d'interrompre cette liaison. Les bornes 70a, 70b peuvent également être reliées à une charge 80 simulant la charge normale qui est appliquée à une ligne de dérivation en fonctionnement non émetteur et non récepteur, cette liaison pouvant être réalisée par le commutateur 82, ou à simuler un court-circuit qui peut être réalisé par la ligne conductrice 84 par l'intermédiaire du commutateur 86. La carte "abonné" comporte également un circuit de commande 88 qui permet de commander individuellement la position ouverte ou fermée des commutateurs 76, 78, 82 et 86 selon l'état dans lequel la ligne dérivée associée à la carte "abonné" doit être placée. En d'autres termes, le circuit de commande 88 reçoit sur l'entrée de commande de la carte 30a une série d'instructions qui commandent la fermeture d'un des quatre interrupteurs, les trois autres restants en position ouverte.

Les commutateurs -élémentaires bi-polaires K peuvent être de nature quelconque. De même, les moyens de commande du "contact mobile" des commutateurs, qui ne sont symbolisés sur les figures 2 et 3 que par des traits en pointillés, peuvent être de nature quelconque. On peut utiliser en particulier des relais dont l'état est commandé par l'intermédiaire d'opto-coupleurs.

La figure 3 montre un mode préféré de réalisation du commutateur 28. Celui-ci a exactement la même architecture que le commutateur 26. On comprend simplement que ce qui constituait les bornes externes de sortie constitue maintenant les bornes externes d'entrée 42a et 42b du commutateur pour relier chaque carte "abonné" 30 à l'appareil de mesure électrique 22. Plus précisément, comme le montre la figure 3, ce sont les bornes 74a et 74b de la carte "abonné" 30 qui sont reliées aux bornes externes d'entrée 42a et 42b du commutateur 28. Celui-ci est commandé par ligne par le circuit de commande 90 qui reçoit ses instructions sur l'entrée 28a.

La structure arborescente des commutateurs 26 et 28 présente de nombreux avantages. D'une part, la commande du commutateur est simplifiée puisqu'il suffit de fournir p informations binaires pour relier les bornes externes connectées au générateur de signaux ou à l'appareil de mesure à une parmi les 2P paires de bornes reliées aux cartes "abonné". D'autre part, chaque trajet électrique défini entre la paire de bornes d'entrée et une quelconque des bornes de sortie comporte le même nombre de contacts intermédiaires, ce qui assure les mêmes qualités de conduction électrique quel que soit le trajet, les longueurs de trajet étant par ailleurs toutes sensiblement égales. De plus,pour chaque commande des commutateurs élémentaires, ceux-ci définissent seulement deux trajets électriques qui vont effectivement des bornes d'entrée à une paire de bornes de sortie et aucun trajet partiel vu des bornes d'entrée, ce qui évite des phénomènes parasites qui pourraient être induits par des trajets partiels reliés aux bornes d'entrée.

## Revendications

1. Dispositif de tests électriques d'un élément de liaison électrique constitué par une ligne principale et n lignes de dérivations raccordées à la ligne principale par des coupleurs, se caractérisé en ce qu'il comprend :
m circuits d'état de ligne de dérivation (30), m ≥ n, chaque circuit d'état (70a, 70b) comprenant une entrée connectée à une ligne de dérivation (16), des moyens commutateurs (76, 78, 82, 86) pour relier ladite entrée à une parmi deux paires de sorties (72a, 72b; 74a, 74b) ou à au moins un composant (80, 84) interne audit circuit et des moyens de commande (88) pour commander lesdits moyens commutateurs ;
un générateur de signaux électriques commandable (24) ;
un premier ensemble de commutation (26) comprenant une entrée reliée audit générateur de signaux (24) , m paires de bornes de sortie de connexion (40a, 40b), chaque paire de bornes de sortie de connexion étant reliée électriquement à la première paire de sortie (72a, 72b) d'un desdits circuits d'état de ligne de dérivation (30), et des moyens de commande (60) pour relier sélectivement ladite entrée à une desdites paires de bornes de sortie de connexion dudit premier ensemble de commutation ;
un dispositif de mesure de signaux électriques (22) ;
un deuxième ensemble de commutation (28) comprenant une sortie reliée audit dispositif de mesure (22), m paires de bornes d'entrée de connexion (42a, 42b), chaque paire de bornes d'entrée étant reliée électriquement à la deuxième paire de sortie (74a, 74b) d'un des circuits d'état de ligne de dérivation (30), et des moyens de commande (90) pour relier sélectivement ladite sortie à une desdites paires de bornes d'entrée de connexion dudit deuxième ensemble de commutation ; et
un ensemble de commande (20) pour commander lesdits moyens de commande des circuits d'état de ligne de dérivation et desdits premier et deuxième ensembles de commutation et pour commander l'élaboration d'un signal électrique par ledit générateur de signaux (24) en fonction d'un programme de tests dudit élément de liaison électrique.

2. Dispositif de tests électriques selon la revendication 1, caractérisé en ce que chaque ensemble de commutations comprend :
deux bornes externes formant ladite entrée du premier ensemble de commutation et de ladite sortie du deuxième ensemble de commutation ;
p lignes de commutateurs, 2P ≥ m, la ligne i comportant 2ⁱ commutateurs, chaque commutateur (K) comprenant une borne d'entrée (a), une première (b) et une deuxième (c) borne de sortie et des moyens de liaison électrique commandables pour relier sélectivement ladite borne d'entrée à ladite première borne ou à ladite deuxième borne de sortie, chacune desdites première ou deuxième bornes de sortie des commutateurs de la ligne i étant reliée électriquement à la borne d'entrée (a) d'un commutateur de la ligne i+1, les deux bornes externes étant reliées respectivement aux bornes d'entrée des deux commutateurs (K_{1,1}, K_{1,2}) de la première ligne ; et
des moyens de commande (60, 90) pour commander simultanément les moyens de liaison électrique commandables de la totalité des commutateurs d'une même ligne de telle manière que, pour tous les commutateurs (K_{i,j}) d'une même ligne la borne d'entrée (a) soit reliée à la première borne de sortie (b) ou soit reliée à la deuxième borne (c) de sortie selon les états binaires de commande ;
chacune des 2P premières bornes de sortie et chacune des 2P deuxièmes bornes de sortie étant reliée à l'une des bornes d'entrée ou de sortie de connexion et les premières et deuxièmes bornes de sortie des commutateurs de la i^{ième} lignes étant reliées aux bornes d'entrée des commutateurs de la (i+1)^{ième} lignes de telle manière que, pour chaque combinaison des états binaires de commande des moyens de commande des lignes de commutateurs, les deux bornes externes dudit ensemble de commutation puissent être reliées à une quelconque unique paire de bornes d'entrée (42a, 42b) ou de sortie (40a, 40b) de connexion.

3. Dispositif de tests électriques selon l'une quelconque des revendications 1 et 2, caractérisé en ce que chaque circuit d'état de ligne de dérivation (30) comprend des premiers moyens commutateurs (76, 78) pour relier directement ladite entrée (70) à l'une ou l'autre des deux paires de sorties (72a, 72b; 74a, 74b) ou pour supprimer cette liaison, des deuxième moyens commutateurs (76, 78, 82) pour relier une desdites paires de sortie à une charge électrique (80), des troisièmes moyens commutateurs (76, 78, 86) pour mettre en court-circuit (84) une des deux paires de sorties, et des moyens de commande séparée (88) de la position desdits premiers, deuxièmes et troisièmes moyens de commutation.

## Patentansprüche

1. Vorrichtung zum elektrischen Prüfen eines Elements einer elektrischen Verbindung, die von einer Hauptleitung und n mit der Hauptleitung durch Kupplungen verbundenen Zweigleitungen gebildet ist, **dadurch gekennzeichnet**, daß sie folgendes aufweist:
m Zweigleitungs-Zustandsschaltungen (30), m ≥ n, wobei jede Zustandsschaltung (70a, 70b) einen mit einer Zweigleitung (16) verbundenen Eingang, Kommutatormittel (76, 78, 82, 86) zur Verbindung des Eingangs mit einem von zwei Ausgangspaaren (72a, 72b; 74a, 74b) oder mit mindestens einem innerhalb der Schaltung befindlichen Bauteil (80, 84) und Steuerungsmitteln (88) zum Steuern der Kommutatormittel aufweist;
einen steuerbaren elektrischen Signalgeber (24);
eine erste Kommutatoreinheit (26), die einen mit dem Signalgeber (24) verbundenen Eingang, m Paare Ausgangs-Anschlußklemmen (40a, 40b), von denen jedes mit dem ersten Ausgangspaar (72a, 72b) einer Zweigleitungs-Zustandsschaltung (30) elektrisch verbunden ist, und Steuermittel (60) aufweist, um selektiv den Eingang mit einem der Ausgangs-Anschlußklemmenpaare der Kommutatoreinheit zu verbinden;
eine Vorrichtung zum Messen elektrischer Signale (22);
eine zweite Kommutatoreinheit (28), die einen mit der Meßvorrichtung (22) verbundenen Ausgang, m Paare Eingangs-Anschlußklemmen (42a, 42b), von denen jedes mit dem zweiten Ausgangspaar (74a, 74b) von einer der Zweigleitungs-Zustandsschaltungen (30) elektrisch verbunden ist, und Steuermittel (90) aufweist, um selektiv den Ausgang mit einem der Eingangs-Anschlußklemmenpaare der zweiten Kommutatoreinheit zu verbinden; und
eine Steuereinheit (20), um die Steuermittel der Zweigleitungs-Zustandsschaltungen sowie der ersten und zweiten Kommutatoreinheit zu steuern sowie um die Verarbeitung eines elektrischen Signals durch den Signalgeber (24) in Abhängigkeit von einem Programm zum Prüfen des Elements einer elektrischen Verbindung zu steuern.

2. Vorrichtung nach Anspruch 1, **dadurch gekennzeichnet**, daß jede Kommutatoreinheit folgendes aufweist:
zwei Außenklemmen, die den Eingang der ersten Kommutatoreinheit und des Ausgangs der zweiten Kommutatoreinheit bilden;
p Kommutatorleitungen, 2P ≥ m, wobei die Leitung i mit 2i Kommutatoren (K) versehen ist, von denen jeder eine Eingangsklemme (a) eine erste (b) und eine zweite (c) Ausgangsklemme sowie Mittel zur elektrischen Verbindung aufweist, die steuerbar sind, um selektiv die Eingangsklemme mit der ersten oder der zweiten Ausgangsklemme zu verbinden, wobei jede der ersten oder zweiten Ausgangsklemmen der Kommutatoren der Leitung i mit der Eingangsklemme (a) eines Kommutators der Leitung i + 1 elektrisch verbunden ist und die Außenklemmen entsprechend mit den Eingangsklemmen der beiden Kommutatoren (K_{1,1}, K_{1,2}) der ersten Leitung verbunden sind; und
Steuermittel (60, 90), um gleichzeitig die Mittel zur elektrischen Verbindung zu steuern, die von der Gesamtheit der Kommutatoren derselben Leitung derart steuerbar sind, daß für alle Kommutatoren (K_{i,j}) derselben Leitung die Eingangsklemme (a) mit der ersten Ausgangsklemme (b) oder mit der zweiten Ausgangsklemme (c) gemäß den binären Steuerzuständen verbunden ist;
jede der 2P ersten Ausgangsklemmen und jede der 2P zweiten Ausgangsklemmen ist mit einer der Eingangs- oder der Ausgangs-Anschlußklemmen verbunden und die ersten und zweiten Ausgangsklemmen der Kommutatoren der i-ten Leitung sind mit den Eingangsklemmen der Kommutatoren der i + 1-ten Leitung derart verbunden, daß für jede Kombination der binären Steuerzustände zur Steuerung der Steuerungsmittel der Kommutatorleitungen die zwei Außenklemmen der Kommutatoreinheit mit irgendeinem einzigen Eingangs- (42a, 42b) oder Ausgangs- (40a, 40b) Anschlußklemmenpaar verbunden werden können.

3. Vorrichtung nach einem der Ansprüche 1 und 2, **dadurch gekennzeichnet**, daß jede Zweigleitungs-Zustandsschaltung (30) erste Kommutatormittel (76, 78), um den Eingang (70) direkt mit dem einen oder dem anderen der beiden Ausgangspaare (72a, 72b; 74a, 74b) zu verbinden oder um diese Verbindung zu unterdrücken, zweite Kommutatormittel (76, 78, 82), um eines der Ausgangspaare mit einer elektrischen Ladung (80) zu verbinden, dritte Kommutatormittel (76, 78, 86), um eines der zwei Ausgangspaare in Kurzschluß (84) zu bringen, und Mittel (88) zur gesonderten Steuerung der Position der ersten, zweiten und dritten Kommutatormittel aufweist.

## Claims

1. Electrical test apparatus for electrically testing an electrical connection member constituted by a main line and n branch lines connected to the main line by couplers, the apparatus being characterized in that it comprises:
m branch line state circuits (30), m ≥ n, each state circuit (70a, 70b) having an input connected to a branch line (16), switch means (76, 78, 82, 86) for connecting said input to one of two pairs of outputs (72a, 72b; 74a, 74b) or to at least one internal component (80, 84) in said circuit, and control means (88) for controlling said switch means;
a controllable electrical signal generator (24);
a first switching assembly (26) comprising an input connected to said signal generator (24), m pairs of switching output terminals (40a, 40b), each pair of switching output terminals being electrically connected to the first pair of output (72a, 72b) of one of said branch line state circuits (30), and control means (60) for selectively connecting said input to one of said pairs of switching output terminals of said first switching assembly;
an electrical signal measuring apparatus (22);
a second switching assembly (28) having an output connected to said measuring apparatus (22), m pairs of switching input terminals (42a, 42b), each pair of input terminals being electrically connected to the second output pair (74a, 74b) of one of the branch line state circuits (30), and control means (90) for selectively connecting said output to one of said pairs of switching input terminals of said second switching assembly; and
a control unit (20) for controlling said control means of the branch line state circuits and of said first and second switching assemblies, and for controlling the generation of an electrical signal by said signal generator (24) as a function of a program of tests to be applied to said electrical connection member.

2. Electrical test apparatus according to claim 1, characterized in that each switch assembly comprises:
two extemal terminals forming said input of the first switch assembly and said output of the second switch assembly;
p rows of switches, 2^{p} ≥ m, row i having 2ⁱ switches, each switch (K) having an input terminal (a), first and second output terminals (b, c), and controllable electrical connection means for selectively connecting said input terminal to said first output terminal or to said second output terminal, each of said first and second output terminals of switches in row i being electrically connected to the input terminal (a) of a switch in row i+1, the two extemal terminals being connected to respective input terminals of the two switches (K_{1,1}, K_{1,2}) of the first row; and
control means (60, 90) for controlling the controllable electrical connection means of all of the switches in the same row simultaneously in such a manner that for all of the switches (K_{i,j}) of the same row, the input terminal (a) is connected to the second output terminal (b) or is connected to the second output terminal (c) depending on binary control states;
each of the 2p first output terminals and each of the 2p second output terminals being connected to one of the switching input or output terminals, and the first and second output terminals of the switches of the ith row being connected to the input terminals of the switches of the (i+1)th row in such a manner that for each combination of binary control states of the control means of the rows of switches, the two external terminals of said switching assembly can be connected to any one single pair of switching input or output terminals (42a, 42b; 40a, 40b).

3. Electrical test apparatus according to any one of claims 1 and 2, characterized in that each branch line state circuit (30) includes first switch means (76, 78) for directly connecting said input (70) to one or the other of two pairs of outputs (72a, 72b; 74a, 74b) or to omit such connection, second switch means (76, 78, 82) for connecting one of said output pairs to an electrical load (80), third switch means (76, 78, 86) for short circuiting (84) one of the two output pairs, and separate control means (88) for controlling the positions of said first, second and third switch means.
